## Europäisches Patentamt
## European Patent Office
## Office européen des brevets

(11) Veröffentlichungsnummer: **0 069 824**
**B1**

(12) **EUROPÄISCHE PATENTSCHRIFT**

(45) Veröffentlichungstag der Patentschrift:
**07.01.87**

(21) Anmeldenummer: **82102295.1**

(22) Anmeldetag: **02.05.79**

(60) Veröffentlichungsnummer der früheren Anmeldung
nach Art. 76 EPÜ: **0005265**

(51) Int. Cl.⁴: **H 05 K  3/30, H 01 L  41/04**

(54) Verfahren zur Kontaktierung der klebstoffseitigen Elektrode eines elektrischen Bauteiles.

(30) Priorität: **10.05.78  DE 2820403**

(43) Veröffentlichungstag der Anmeldung:
**19.01.83 Patentblatt 83/3**

(45) Bekanntmachung des Hinweises auf die Patenterteilung:
**07.01.87 Patentblatt 87/2**

(84) Benannte Vertragsstaaten:
**AT CH FR IT NL SE**

(56) Entgegenhaltungen:
**FR - A - 2 152 681**
**FR - A - 2 279 307**
**FR - A - 2 326 059**
**US - A - 3 934 336**

(73) Patentinhaber: **Siemens Aktiengesellschaft Berlin und München, Wittelsbacherplatz 2, D-8000 München 2 (DE)**

(72) Erfinder: **Schade, Reinhart, Mozartstrasse 11g, D-8031 Olching (DE)**

ACTORUM AG

## Beschreibung

Die Erfindung bezieht sich auf ein Verfahren zur Kontaktierung nach dem Oberbegriff des Patentanspruches.

Vielfach bestehen bestimmte elektrische Bauteile aus einem zu einem Formteil gestanzten Blech, welches als Träger eines elektrischen Bauelementes dient und mit diesem zu einer Baueinheit fest verbunden ist. Die Verbindung der beiden Teile erfolgt meist durch einen Zweikomponenten- oder Schmelzklebstoff.

Ist eine solche Trägerplatte beispielsweise mit einer scheibenförmigen Piezokeramik verbunden, wie man sie als Uhren-Summerscheibe oder Telefon-Piezowandler benötigt, so spricht man von einer sog. Verbundplatte.

Bei der Anwendung der Verbundplatte als Telefon-Piezowandler muss die Verbundplatte weich gelagert sein, damit die Schwingungen der Piezokeramik nicht beeinflusst werden. Aus diesem Grunde ist bei einer solchen Anwendung eine Druckfederkontaktierung – wie beim Betrieb der Uhren-Summerscheiben – nicht möglich, so dass an die Elektroden dünne, die Schwingungen nicht beeinflussende Anschlussdrähtchen oder -bändchen angelötet werden müssen. Damit dies möglich ist, ist es bereits bekannt (DE-A-2 138 563), dass die klebstoffseitige Elektrode auf die Oberseite der Keramikscheibe herumgeführt werden muss. Für das Herumführen der Elektrode auf die Oberseite muss die Keramikscheibe beim Siebdrucken orientiert und zur Siebkonfiguration positioniert werden. Dies ist bei der bruchempfindlichen Piezokeramik und bei der erforderlichen Genauigkeit nicht unproblematisch.

Durch die US-A-2 877 363 ist es bekannt, zur Kontaktierung von Piezowandlern als kontaktbildendes Mittel eine besonders gestaltete elektrische Zuleitung zu verwenden, die vor dem Fügevorgang auf die klebstoffbeschichtete Seite des Piezowandlers aufgelegt wird. Da die Dicke der elektrischen Zuleitung geringer ist als die Stärke der Klebstoffschicht, ist das mit dem Piezowandler in Kontakt tretende Ende der elektrischen Zuleitung wellenförmig ausgebildet, wobei die Amplitude dieser Wellen grösser ist als die Dicke der Klebstoffschicht. Diese Ausbildung ist insbesondere dann von Vorteil, wenn zwei zu einem Paar zusammengefügte Piezowandler kontaktiert werden sollen.

Der Erfindung liegt die Aufgabe zugrunde, ein Verfahren zur Kontaktierung der klebstoffseitigen Elektrode eines elektrischen Bauteils zu schaffen, das nicht nur einfacher ist als die bekannten Verfahren, sondern auch für eine Automatisierung geeignet ist.

Diese Aufgabe wird gemäss der Erfindung durch die im kennzeichnenden Teil des Patentanspruchs 1 genannten Verfahrensmassnahmen gelöst. Dies ist besonders dann von Vorteil, wenn als Klebemittel ein Copolymerisat verwendet ist. Dieses Klebemittel ist besonders geeignet für ein rationelles Kleben bei der Serienfertigung, da dieser Klebstoff nur eine relativ kurze Abbindezeit benötigt.

Anhand der Zeichnung wird das erfindungsgemässe Verfahren näher erläutert.

Figur 1 dient lediglich zur Erläuterung des Standes der Technik, während

Figur 2 ein Ausführungsbeispiel der Erfindung zeigt.

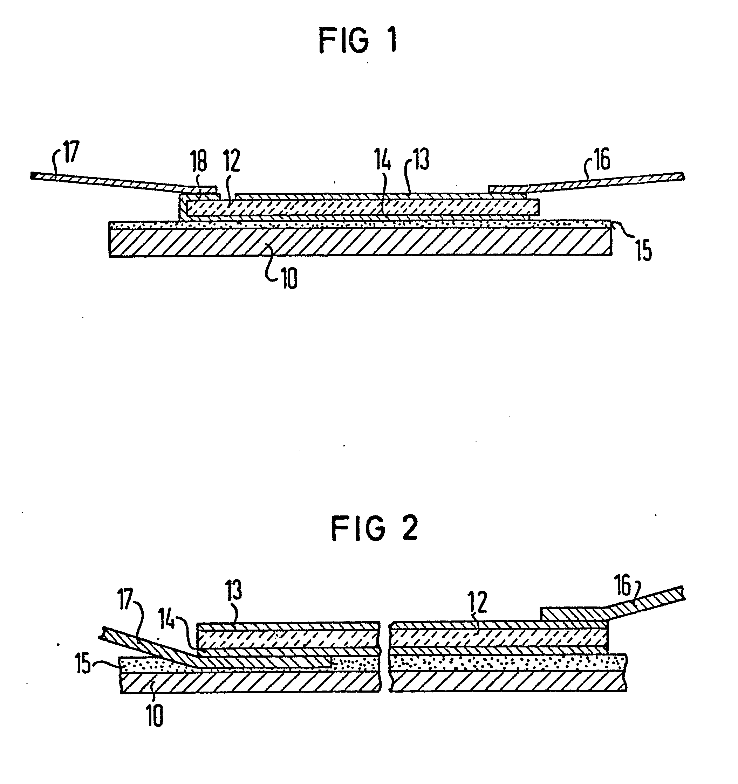

Anhand der Figur 1 wird ein bekanntes Ausführungsbeispiel beschrieben, bei dem insbesondere die isolierenden Eigenschaften des Copolymerisats ausgenutzt werden. Sie zeigt einen herkömmlichen Telefon-Piezowandler im Schnitt. Mit 10 ist eine Trägerplatte bezeichnet, auf der einseitig eine Copolymerisat-Schicht 15 aufgebracht wurde. Mit Hilfe dieser Klebstoffschicht 15 ist eine mit Elektroden 13 und 14 versehene Piezokeramikscheibe 12 zu einer Verbundplatte verbunden. Da diese Verbundplatte weich gelagert sein muss, werden an die Elektroden dünne, die Schwingungen nicht beeinflussende Anschlussdrähtchen oder -bändchen 16 und 17 auf die Elektroden 13 und 14 angelötet. Aus diesem Grunde ist die klebstoffseitige Elektrode 14 über die Kante der Piezokeramikscheibe 12 herumgeführt, wie durch 18 angedeutet ist. Diese Art der Elektrodenführung ist z. B. durch DE-A-2 138 563 bekannt. Das Aufbringen derartiger Elektroden ist jedoch aufwendig. Beim Siebdrucken z. B. muss die Keramikscheibe zentriert und zur Siebkonfiguration positioniert werden. Dies ist bei dem bruchempfindlichen Druckgut und bei der erforderlichen Genauigkeit nicht unproblematisch. Bringt man die Elektroden im Aufdampfverfahren auf, dann müssen metallisch freie Zonen abgedeckt werden.

Figur 2 zeigt nun ein Auführungsbeispiel, bei dem ganflächige Elektroden verwendet werden. Gleichwirkende Teile sind mit gleichen Bezugszeichen wie in Figur 1 versehen. Zur Kontaktierung der vereinfachten, nicht auf die Oberseite geführten klebstoffseitigen Elektrode 14 dient ein blankes, nicht isoliertes Drähtchen oder -bändchen 17, das etwas dünner als die Klebstoffschicht 15 ist, da die klebstoffseitige Elektrode 14 keinen elektrischen Kontakt mit der Trägerplatte 10 zu haben braucht. Das Bändchen 17 wird entweder nur zu einem Teil oder über den gesamten Durchmesser unter die aufzuklebende Keramikscheibe 12 gelegt. Vorzugsweise wird ein metallisch harter Aufpresstempel zum Anpressen der Keramikscheibe 12 verwendet, um eine Rissbildung in der meist dünnen Piezokeramikscheibe 12 zu vermeiden. Da das vorzugsweise verwendete Coplymerisat 15 während des Heissklebens bei ca. 120° nicht flüssig ist, fliesst der Klebstoff auch nicht zwischen die zu kontaktierenden Flächen der Elektrode 14 und Bändchen 17. Die zweite Elektrode 13 wird – wie bisher – durch ein aufgelötetes Bändchen 16 kontaktiert.

## Patentansprüche

1. Verfahren zum Kontaktieren eines plattenförmigen elektrischen Bauelementes, insbesondere eines piezoelektrischen Bauelementes, das beidseitig mit je einer ganzflächigen Elektrode versehen ist, und das mittels eines isolierenden Klebstoffes mit einer elektrisch leitenden Trägerplatte mechanisch verbunden ist, dadurch gekennzeichnet, dass zur Kontaktierung der zwischen dem Bauelement und der Trägerplatte angeordneten Elektrode folgende zeitlich aufeinanderfolgenden Verfahrensschritte auszuführen sind:

a) eine bei Heissklebung nicht flüssige Klebstoffschicht (15) wird auf die Trägerplatte (10) in einer vorgegebenen Schichtstärke aufgebracht;

b) ein gestrecktes, blankes Anschlussbändchen (17), dessen Stärke geringer ist als die Dicke der Klebstoffschicht, wird unter das Bauelement gelegt;

c) zur Heissklebung wird das Bauelement an die Trägerplatte unter Wärmeeinwirkung und unter Beibehaltung des Kontaktes mit der klebstoffseitigen Elektrode (14) derart angepresst, dass sich das Anschlussbändchen in die Klebstoffschicht eindrückt, die Trägerplatte jedoch nicht kontaktiert.

2. Verfahren nach Anspruch 1, gekennzeichnet durch die Verwendung eines Copolymerisats als Klebemittel.

**Claims**

1. A method of contacting a plate-shaped electrical component, particularly but not exclusively, a piezo-electric component, which is provided on both sides with an electrode covering the entire area and which is mechanically connected to an electrically-conductive carrier plate by means of an insulating adhesive, characterised in that in order to contact the electrode which is arranged between the component and the carrier plate, the following steps are consecutively carried out:

a) an adhesive layer (15) which is not liquified during hot adhesion is applied to the carrier plate (10) in a predetermined layer thickness;

b) an elongate bare connecting strip (17), the thickness of which is less than the thickness of the adhesive layer, is positioned below the component;

c) for hot adhesion, the component is pressed against the carrier plate under the influence of heat and whilst continuing the contact with the electrode (14) on the adhesive side, in such a manner that the connecting strip is pressed into the adhesive layer but does not contact the carrier plate.

2. A method as claimed in Claim 1, characterised by the use of a copolymer as adhesive.

**Revendications**

1. Procédé pour établir des contacts sur un composant électrique en forme de plaque, notamment un composant piézoélectrique qui comporte sur ses deux faces respectivement une électrode s'étendant sur toute la surface du composant et qui est reliée mécaniquement au moyen d'une colle isolante à une plaque de support électriquement conductrice, caractérisé par le fait que pour établir les contacts avec l'électrode située entre le composant et la plaque de support, il faut exécuter les phases opératoires successives suivantes:

a) on dépose une couche de colle (15), non liquide dans le cas d'un collage à chaud, sur la plaque de support (10), et ce sur une épaisseur de couche prédéterminée;

b) on dépose au-dessous du composant une petite bande nue de raccordement (17), dont l'épaisseur est inférieure à l'épaisseur de la couche de colle,

c) pour réaliser le collage à chaud, on comprime le composant sur la plaque du support moyennant l'action d'une chaleur et tout en maintenant le contact avec l'électrode (14) située du côté de la colle de telle sorte que la petite bande de raccordement pénètre dans la couche de colle, mais sans contacter la plaque de support.

2. Procédé suivant la revendication 1, caractérisé par l'utilisation d'un copolymère en tant que colle.

# FIG 1

# FIG 2